# EUROPÄISCHE PATENTANMELDUNG

(11) **EP 4 701 358 A1**
(43) Veröffentlichungstag der Anmeldung: **25.02.2026**
(21) Anmeldenummer: 24195911.3
(22) Anmeldetag: 22.08.2024
(51) Int. Cl.: H05K 7/20

(54) **KÜHLUNG EINES ELEKTRISCHEN MODULS**

(71) Anmelder: Siemens Aktiengesellschaft, 80333 München (DE)
(72) Erfinder: Bigl, Thomas, 91074 Herzogenaurach (DE); Danov, Vladimir, 91056 Erlangen (DE); Grundmann, Jörn, 91091 Großenseebach (DE); Madkour, Sherif, 12159 Berlin (DE); Müller, Volker, 90459 Nürnberg (DE); Neugebauer, Stephan, 91058 Erlangen (DE); Reissner, Florian, 90411 Nürnberg (DE); Schwarz, Florian, 91466 Gerhardshofen (DE)
(74) Vertreter: Siemens Patent Attorneys

(57) **Zusammenfassung**

Es wird ein elektrisches Modul (30) mit wenigstens einem elektrischen Bauelement (35) und einer Kühlvorrichtung (1) zur Kühlung des elektrischen Bauelements (35) angegeben,
- wobei die Kühlvorrichtung (1) einen ringförmig geschlossenen länglichen Medienkanal (3) zur Zirkulation eines fluiden Arbeitsmediums (M) in einem geschlossenen Kreislauf aufweist,
- wobei der ringförmig geschlossene Medienkanal (3) durch eine Kanalwand (5) begrenzt ist, welche wenigstens in einem Teilbereich (40) in ihrer lokalen Längsrichtung (x) in eine Mehrzahl von miteinander abwechselnden Warmsegmenten (W) und Kaltsegmenten (K) unterteilt ist,
- wobei die Warmsegmente (W) jeweils im Bereich des wenigstens einen elektrischen Bauelements (35) angeordnet sind und thermisch derart mit diesem gekoppelt sind, dass sie eine Entwärmung des elektrischen Bauelements (35) mittels eines lokalen Wärmeeintrags (Qᵢₙ) in das fluide Arbeitsmedium (M) über das jeweilige Warmsegment (W) der Kanalwand (5) ermöglichen,
- wobei zwischen den einander benachbarten Warmsegmenten (W) und Kaltsegmenten (K) jeweils ein Übergangsbereich (T) gebildet ist,
- und wobei in wenigstens einer Teilmenge dieser Übergangsbereiche (T) jeweils wenigstens ein strömungsleitendes Element (7) angeordnet ist, mit welchem einem durch den lokalen Wärmeeintrag (Qᵢₙ) thermisch angetriebenen Transport des fluiden Arbeitsmediums (M) eine Vorzugsrichtung (r) aufgeprägt werden kann.

Weiterhin wird eine entsprechende Kühlvorrichtung (1) sowie ein entsprechendes Betriebsverfahren angegeben.

## Beschreibung

Die vorliegende Erfindung betrifft ein elektrisches Modul mit wenigstens einem elektrischen Bauelement und einer Kühlvorrichtung zur Kühlung des elektrischen Bauelements, wobei die Kühlvorrichtung einen ringförmig geschlossenen länglichen Medienkanal zur Zirkulation eines fluiden Arbeitsmediums in einem geschlossenen Kreislauf aufweist. Weiterhin betrifft die Erfindung ein Verfahren zum Betrieb eines solchen elektrischen Moduls.

Aus dem Stand der Technik sind vielfältige Kühlmethoden für elektrische und elektronische Module bekannt, die zur Abführung von Verlustwärme aus elektrischen Bauelementen dienen. Vor allem im Bereich leistungselektronischer Bauelemente stellt die Abführung der beim Betrieb freigesetzten Wärme ein immer größeres Problem dar, da ein ungebrochener Trend zur Steigerung der Leistungen bei gleichzeitiger Miniaturisierung der Module besteht.

Ein vergleichsweise einfacher Ansatz zur Kühlung von elektrischen Modulen stellt die Luftkühlung dar. Hierbei wird meist Umgebungsluft über einen in das Modul eingebauten Lüfter durch das Innere eines Modulgehäuses zirkuliert, um eine Wärmeabgabe an die Umgebungsluft zu fördern und so die von den elektrischen Bauelementen dissipierte Wärme abzuführen. Dieser Ansatz wird häufig bei elektrischen Modulen mit niedriger Leistung und im niedrigen Preissegment gewählt. Bei Modulen der Leistungselektronik mit höheren Leistungsdichten kann damit jedoch meist keine ausreichende Entwärmung mehr bewirkt werden.

Ein alternativer Ansatz zur Kühlung von elektrischen Modulen stellt die Flüssigkeitskühlung dar. Flüssig gekühlte elektrische Module sind vor allem bei industriellen Anwendungen verbreitet, bei denen die Leistungsdichten höher sind und entsprechend ein höherer apparativer und preislicher Aufwand beim Kühlsystem zu vertreten ist. Typischerweise wird dabei ein Teil der elektrischen Bauelemente thermisch an einen Kühlköper angekoppelt. Dieser Kühlkörper enthält Kühlkanäle zur Zirkulation eines flüssigen Kühlmediums, wobei das flüssige Kühlmedium die Wärme aus dem Kühlkörper aufnehmen und in einen Bereich außerhalb des Modulgehäuses abführen kann. Das Gehäuse ist dazu entsprechend mit einem Einlass und einem Auslass für das flüssige Kühlmedium ausgestattet. Das Kühlmedium wird meist mit einer außerhalb des Modulgehäuses liegenden Pumpe durch das entsprechende Leitungssystem gepumpt. Nachteilig sind bei diesem Ansatz die Erhöhung der Schnittstellen des Moduls aufgrund der zusätzlichen Kühlmittelleitungen, der Energieverbrauch der außenliegenden Pumpe und die erhöhte Komplexität des inneren Aufbaus des Moduls, wobei bei der Wahl der Materialien zum Teil auch eine Kompatibilität mit dem verwendeten flüssigen Kühlmedium berücksichtigt werden muss. Auch der Wartungsaufwand eines solchen flüssiggekühlten elektrischen Moduls ist aufgrund der höheren Komplexität im Vergleich zu einem luftgekühlten Modul häufig erhöht.

Eine weitere bekannte Kühlmethode für elektrische Module basiert auf dem Prinzip der Wärmerohre (Heatpipes). Allgemein ist ein Wärmerohr ein Wärmeübertrager, der durch die Nutzung der Verdampfungsenthalpie eines fluiden Arbeitsmediums eine hohe Wärmestromdichte erlaubt. Das Arbeitsmedium wird dabei in einem geschlossenen Innenraum (Kavität) in einem geschlossenen Kreislauf zwischen einem Verdampferbereich und einem Kondensatorbereich zirkuliert. Dabei geht das Arbeitsmedium in dem Verdampferbereich unter Aufnahme von Wärme vom flüssigen in den gasförmigen Aggregatzustand über und in dem Kondensatorbereich unter Abgabe von Wärme vom gasförmigen in den flüssigen Aggregatzustand über. Entsprechend ist dem Verdampferbereich ein zu entwärmender Teil des Wärmerohrs zugeordnet, und dem Kondensatorbereich ist ein zu erwärmender Teil des Wärmerohrs zugeordnet. Auf diese Weise können große Wärmemengen auf kleiner Querschnittsfläche übertragen werden. Bei einem konventionellen Wärmerohr erfolgt der Rücktransport von kondensiertem Arbeitsmedium vom Kondensatorbereich zum Verdampferbereich mittels kapillarem Transport durch eine innerhalb der Kavität angeordnete Kapillarstruktur.

Eine pulsierende Heatpipe (PHP) ist ein spezielles Wärmerohr mit einem geschlossenen Innenraum zum Transport eines fluiden Arbeitsmediums in einem selbständig pulsierenden Betrieb, wie beispielsweise in der Europäischen Patentanmeldung EP 3 823 018 A1 beschrieben. Im Unterschied zum konventionellen Wärmerohr wird hier also der Rücktransport des kondensierten Arbeitsmediums zur Wärmequelle durch ein eigenständiges Pulsieren des Arbeitsmediums bewirkt. Um dies zu ermöglichen, weist der Innenraum des Wärmerohrs eine vergleichsweise enge kanalartige Struktur auf. Der gebildete Medienkanal ist so eng ausgestaltet, dass sich durch die Oberflächenspannung des kondensierten Arbeitsmediums miteinander abwechselnde und jeweils in sich zusammenhängende Segmente aus Flüssigkeit und Dampf ausbilden. An der warmen Seite des Wärmerohrs dehnen sich die Dampfsegmente aus und schrumpfen an der kalten Seite des Wärmerohrs, wobei auch eine anteilige Kondensation erfolgt. In der PHP liegen dadurch stets lokale Temperatur- und Druckunterschiede vor, deren Ausgleich das zweiphasige System durch in Längsrichtung verschiebende Kräfte auf die Flüssigkeits- und Dampfsegmente anstrebt. Diese Ausgleichskräfte führen zu einer ständigen oszillierenden bzw. pulsierenden Bewegung der einzelnen Segmente, die sich ohne einen aktiven äußeren Antrieb allein durch den Temperaturunterschied und aufgrund der Oberflächenspannung innerhalb des Medienkanals automatisch einstellt. Insbesondere erreicht das System nie ein statisches Gleichgewicht, sondern das Pulsieren wird aufrechterhalten, solange ein Temperaturunterschied besteht und solange eine Aufteilung in abwechselnde Längssegmente aus Flüssigkeit und Dampf vorliegt. Diese Bewegung wird auch als selbst-oszillierende Zweiphasenströmung bezeichnet. Insgesamt können mit einer solchen PHP deutlich geringere Wärmewiderstände erreicht werden als mit einem konventionellen Wärmerohr. Eine effiziente Wärmeübertragung mit einem solchen Zweiphasensystem erfordert jedoch typischerweise relativ komplexe und feingranulare Strukturen, deren geometrische Vorgaben bei der Fertigung sehr genau eingehalten werden müssen, um die Ausbildung der selbst-oszillierenden Zweiphasenströmung zu gewährleisten. Daher ist die Herstellung solcher PHPs mit einem hohen apparativen Aufwand verbunden.

Aufgabe der Erfindung ist es daher, ein elektrisches Modul anzugeben, welches die genannten Nachteile überwindet. Insbesondere soll ein elektrisches Modul mit einer alternativen Kühlvorrichtung zur Verfügung gestellt werden, welche eine effektive Wärmeabfuhr der enthaltenen elektrischen Bauelemente bei hohen Leistungsdichten ermöglicht. Dies soll insbesondere bei einer geringen apparativen Komplexität realisiert werden, vor allem in Bezug auf die äußeren Schnittstellen des Moduls. Eine weitere Aufgabe ist es, eine entsprechende Kühlvorrichtung sowie ein Betriebsverfahren für ein solches elektrisches Modul anzugeben, mit dem eine derartige Kühlung realisiert werden kann.

Diese Aufgaben werden durch das in Anspruch 1 beschriebene elektrische Modul, die in Anspruch 13 beschriebene Kühlvorrichtung und das in Anspruch 14 beschriebene Betriebsverfahren gelöst.

Das erfindungsgemäße elektrische Modul weist wenigstens ein elektrisches Bauelement und eine Kühlvorrichtung zur Kühlung des elektrischen Bauelements auf, wobei die Kühlvorrichtung einen ringförmig geschlossenen länglichen Medienkanal zur Zirkulation eines fluiden Arbeitsmediums in einem geschlossenen Kreislauf aufweist. Der ringförmig geschlossene Medienkanal ist durch eine Kanalwand begrenzt, welche wenigstens in einem Teilbereich in ihrer lokalen Längsrichtung in eine Mehrzahl von periodisch miteinander abwechselnden Warmsegmenten und Kaltsegmenten unterteilt ist. Die Warmsegmente sind dabei jeweils im Bereich des wenigstens einen elektrischen Bauelements angeordnet und thermisch derart mit diesem gekoppelt, dass sie eine Entwärmung des elektrischen Bauelements mittels eines lokalen Wärmeeintrags in das fluide Arbeitsmedium über das jeweilige Warmsegment der Kanalwand ermöglichen. Zwischen den einander benachbarten Warmsegmenten und Kaltsegmenten ist jeweils ein Übergangsbereich gebildet, wobei in wenigstens einer Teilmenge dieser Übergangsbereiche jeweils wenigstens ein strömungsleitendes Element angeordnet ist, mit welchem einem durch den lokalen Wärmeeintrag thermisch angetriebenen Transport des fluiden Arbeitsmediums eine Vorzugsrichtung aufgeprägt werden kann.

Die genannten Warmsegmente und Kaltsegmente bilden also jeweils Längssegmente der Kanalwand aus, die den insgesamt länglich geformten Medienkanal umschließt. Der Medienkanal muss dabei nicht zwangsläufig gerade sein, sondern kann gebogene Abschnitte und beispielsweise mäanderförmige Windungen aufweisen. Er hat aber vorteilhaft eine insgesamt längliche Form, die in eine Anzahl von Streckenabschnitten (den Längssegmenten) unterteilbar ist. Entsprechend ist für eine lokale Position des Medienkanals jeweils eine lokale Längsrichtung definiert, die im Folgenden auch als axiale Richtung bezeichnet wird. Die Warmsegmente zeichnen sich dadurch aus, dass sie beim Betrieb des elektrischen Moduls wärmer sind als die dazwischenliegenden Kaltsegmente. Dies beruht darauf, dass sie im Bereich der vorhandenen elektrischen Bauelemente angeordnet sind, insbesondere weisen sie in axialer Richtung eine gleiche oder überlappende Position auf wie ein jeweils zugeordnetes elektrisches Bauelement. Die Warmsegmente weisen also insbesondere einen kürzeren Abstand und eine engere thermische Ankopplung zu den vorhandenen elektrischen Bauelementen auf als die Kaltsegmente. Ein Warmsegment ist jeweils einem elektrischen Bauelement zugeordnet, mit dem es entweder in direktem Kontakt ist oder mit dem es über ein dünnes, hochwärmeleitendes Zwischenelement verbunden ist.

Insgesamt kann auch eine Mehrzahl von elektrischen Bauelementen vorliegen, die über den Medienkanal entwärmt werden und die jeweils einem oder mehreren der insgesamt vorhandenen Warmsegmenten zugeordnet sind. Der Wärmetransport über das fluide Arbeitsmedium erfolgt also von den Warmsegmenten der Kanalwand zu den (beim Betrieb kühleren) Kaltsegmenten der Kanalwand. Im Bereich der Warmsegmente findet ein Wärmeeintrag in das Arbeitsmedium statt, und im Bereich der Kaltsegmente findet eine Entwärmung des Arbeitsmediums statt. Die im Bereich der Kaltsegmente entnommene Wärme wird über die Kanalwand beispielsweise an ein angrenzendes Kühlelement übertragen, das in analoger Weise dem Kaltsegment zugeordnet ist und dazu ausgelegt ist, Wärme an eine Umgebung des elektrischen Moduls abzuführen.

Insgesamt liegen mehrere Warmsegmente und mehrere Kaltsegmente vor, die zumindest in einem Teilbereich der gesamten Länge des Medienkanals miteinander abwechseln. Sie können insbesondere in einer periodischen Struktur miteinander abwechseln, also mit anderen Worten in einem regelmäßigen Muster. Insbesondere kann dabei die Länge der einzelnen Warmsegmente, die Länge der einzelnen Kaltsegmente und/oder der Abstand der Zentren der jeweils benachbarten Längssegmente über den betrachteten Teilbereich konstant sein. Das regelmäßige Muster kann eine feste räumliche Wiederholungslänge aufweisen, mit der sich eine Elementarzelle des Musters eindimensional periodisch wiederholt. Durch einen solchen regelmäßigen Wechsel aus abwechselnden Warmsegmenten und Kaltsegmenten wird erreicht, dass sich ähnlich wie bei der oben beschriebenen PHP ein thermisch getriebener Medientransport entlang einer Längsrichtung des Medienkanals einstellt. Im Unterschied zu einer PHP ist der Medienkanal des erfindungsgemäßen Moduls nicht für ein zweiphasiges oszillierendes System, sondern für einen einphasigen thermisch induzierten Transport des eingeschlossenen fluiden Arbeitsmediums ausgelegt. Die Ausbildung von Phasengrenzen ist dabei also nicht vorgesehen, und entsprechend muss der Querschnitt der Kanalstruktur nicht an die Randbedingungen einer Oberflächenspannung und eines kapillaren Transports angepasst werden. Somit können die geometrischen Toleranzen breiter sein, und die Fertigung der Strukturen des Medienkanals kann weniger präzise und damit einfacher ausgestaltet werden als bei einer PHP.

Der thermisch getriebene Medientransport stellt sich dadurch ein, dass innerhalb der Warmsegmente durch den Wärmeeintrag in das fluide Arbeitsmedium eine thermische Ausdehnung des Arbeitsmediums bewirkt wird. Durch die Entwärmung im Bereich der Kaltsegmente erfolgt dagegen eine Kontraktion des fluiden Arbeitsmediums. Im Vergleich zu dem fluiden Arbeitsmedium ist die Kanalwand vergleichsweise starr und insbesondere auch weniger stark von Volumenänderungen durch thermische Ausdehnung bzw. Schrumpfung betroffen. So kann ein Ausgleich des zwischen den Warmsegmenten und Kaltsegmenten gebildeten Druckgefälles vor allem durch einen Transport von fluidem Arbeitsmedium entlang der Längsrichtung des Medienkanals erfolgen. Die Temperaturunterschiede bilden also zunächst die Grundlage für ein regelmäßiges Muster von Druckunterschieden. Dieses regelmäßige Muster von Druckunterschieden wird zur Grundlage einer selbsttätig pulsierenden Bewegung, da die beim Ausgleich der Druckunterschiede resultierende Bewegung des Arbeitsmediums erfindungsgemäß durch die strömungsleitenden Elemente in eine Vorzugsrichtung gelenkt wird.

Zwischen einem Paar aus einem Warmsegment und einem benachbarten Kaltsegment ist jeweils ein Übergangsbereich gebildet. Zumindest in einer Teilmenge dieser Übergangsbereiche sind jeweils (pro Übergangsbereich) ein oder mehrere strömungsleitende Elemente angeordnet. Ein solches strömungsleitendes Element bewirkt, dass die Höhe des Strömungswiderstands für das Arbeitsmedium von dem Vorzeichen der axialen Bewegungsrichtung (axial in Bezug auf die lokale Längsrichtung des Medienkanals) abhängt. Der Strömungswiderstand ist also für die Vorzugsrichtung niedriger als für die Gegenrichtung, und es stellt sich insgesamt ein Netto-Medientransport über den gesamten ringförmigen Medienkanal mit einem durch die Geometrie der vorliegenden strömungsleitenden Elemente bestimmten Vorzeichen ein. Als strömungsleitendes Element kann beispielsweise eine schräg liegende Lamelle, eine Düse und/oder ein Teslaventil zum Einsatz kommen. Insgesamt kann eine Mehrzahl von solchen strömungsleitenden Elementen vorliegen. Beispielsweise können ein oder mehrere strömungsleitende Elemente als Teil eines sich regelmäßig wiederholenden Musters im jeweiligen Übergangsbereich zwischen benachbarten Warm- und Kaltsegmenten angeordnet sein. Neben den genannten Übergangsbereichen können auch innerhalb der Warm- und/oder Kaltsegmente solche strömungsleitenden Strukturen angeordnet sein, um dem Transport des Arbeitsmediums noch effektiver eine Vorzugsrichtung einzuprägen.

Insgesamt muss sich die Anordnung aus miteinander abwechselnden Warm- und Kaltsegmenten mit den dazwischenliegenden strömungsleitenden Strukturen nicht zwangsläufig über die gesamte Längsausdehnung des Medienkanals erstrecken. So ist es allgemein ausreichend, wenn der Medienkanal nur auf einem Teilbereich seiner Längsausdehnung auf die beschriebene Weise strukturiert ist. Ein Netto-Medientransport entlang der ausgebildeten Vorzugsrichtung kann sich thermisch induziert zunächst in diesem Teilbereich ausbilden und dann von dort aus über die gesamte Länge des Medienkanals propagieren, bis sich eine stabile Längsströmung entlang dieser Vorzugsrichtung ausbildet. Insgesamt ergibt sich eine selbsttätige Strömung des Arbeitsmediums entlang des Medienkanals, die sich im Unterschied zu einer PHP auch in einem Einphasensystem einstellt.

Der beschriebene thermisch induzierte Transportmechanismus für das fluide Arbeitsmedium kann insbesondere rein passiv getrieben sein, also mit anderen Worten ohne den Einfluss von aktiv bewegten Antriebsstrukturen wie Pumpen oder mikroelektromechanischen Aktoren (MEMS-Aktoren). Die Triebkraft für die Strömung resultiert vielmehr alleine aus den Kontraktionen und/oder Expansionen der Materialien aufgrund der lokalen Temperaturänderungen. In Anlehnung an die Peristaltik eines Darms kann diese Art von thermisch induzierter Längsströmung auch als peristaltik-artiger Transport bezeichnet werden.

Im Unterschied zur Peristaltik des Darms fehlen hier aber die äußeren Aktoren (die beim Darm durch die kontrahierende Muskulatur gegeben sind), weshalb auch der Begriff "passiv induzierte Peristaltik" verwendet werden kann. Wenn die Wärmeabgabe der zu entwärmenden Elemente und die Wärmeaufnahme der Kühlelemente zeitlich konstant ist, kann sich aufgrund des passiv induzierten Fluidtransports allmählich eine gleichmäßige axiale Strömung des Arbeitsmediums einstellen. Noch vorteilhafter ist es jedoch, wenn sich eine pulsierende Längsströmung einstellt, bei der sich ein wellenartiges räumliches Temperaturprofil mit einem Muster aus wechselnden Warm- und Kaltzonen des Arbeitsmediums ringförmig entlang des Medienkanals bewegt. Ein solches pulsierendes Temperaturprofil kann sich prinzipiell schon aufgrund des Musters aus Warm- und Kaltsegmenten im Zusammenspiel mit der Strömungsdynamik des Arbeitsmediums einstellen. Besonders vorteilhaft kann eine solche pulsierende Strömung jedoch durch einen pulsierenden Wärmeeintrag verstärkt werden. Viele elektronische Bauelemente geben ihre Verlustleistung nicht kontinuierlich, sondern zeitlich variierend ab. Wenn der zeitlichen Variation eine vorherrschende Frequenz aufgeprägt ist, kann sich diese Frequenz sowohl dem Wärmeeintrag als auch einem pulsierenden Transport des Arbeitsmediums aufprägen. Auf diese Weise kann ähnlich wie bei der PHP rein thermisch und ohne bewegte Antriebselemente eine pulsierende Strömung induziert werden. Im Unterschied zur PHP wird diese pulsierende Fluidströmung hier jedoch in einem einphasigen Fluidsystem realisiert.

Ein wesentlicher Vorteil des erfindungsgemäßen elektrischen Moduls liegt darin, dass der beschriebene Transportmechanismus einen effektiven Wärmetransport zwischen den Warmsegmenten und den Kaltsegmenten des Medienkanals ermöglicht. So wird eine effektive Entwärmung der vorliegenden elektrischen Bauelemente erreicht, beispielsweise über ein an die Kaltsegmente angekoppeltes Kühlelement. Der thermisch induzierte Fluidtransport kann dabei mit geometrischen Strukturen erreicht werden, welche im Vergleich zu anderen Kühlvorrichtungen wie z.B. einer PHP vergleichsweise einfach und mit geringerer geometrischer Präzision ausgebildet werden können.

Die Erfindung kann auch durch eine einzelne Kühlvorrichtung gemäß Anspruch 13 realisiert sein, welche zur Kühlung einer oder mehrerer Wärmequellen ausgelegt ist und ansonsten analoge Merkmale aufweist wie die Kühlvorrichtung des oben beschriebenen elektrischen Moduls. Die Wärmequellen, welche durch eine solche Kühlvorrichtung gekühlt werden können, können dann ebenfalls ein oder mehrere elektrische Bauelemente oder auch andersartige zu entwärmende Elemente sein.

Das erfindungsgemäße Verfahren dient zum Betrieb eines erfindungsgemäßen elektrischen Moduls. Dabei wird das wenigstens eine elektrische Bauelement mittels eines fluiden Arbeitsmediums gekühlt, welches innerhalb des länglichen Medienkanals in einem geschlossenen Kreislauf zirkuliert. Der Transport des fluiden Arbeitsmediums wird durch den lokalen Wärmeeintrag thermisch angetrieben, und dieser Transport erfolgt entlang einer Vorzugsrichtung, welche durch das wenigstens ein strömungsleitendes Element in einen Stoffstrom des fluiden Arbeitsmediums eingeprägt wird. Die Vorteile des erfindungsgemäßen Verfahrens ergeben sich analog zu den oben beschriebenen Vorteilen des erfindungsgemäßen elektrischen Moduls.

In analoger Weise kann ein Verfahren zum Betrieb einer erfindungsgemäßen Kühlvorrichtung angegeben werden, bei welchem wenigstens eine Wärmequelle mittels eines fluiden Arbeitsmediums gekühlt wird, welches innerhalb des länglichen Medienkanals in einem geschlossenen Kreislauf zirkuliert. Auch hierbei wird der Transport des fluiden Arbeitsmediums durch den lokalen Wärmeeintrag thermisch angetrieben und der Transport erfolgt entlang einer Vorzugsrichtung, welche durch das wenigstens ein strömungsleitendes Element in einen Stoffstrom des fluiden Arbeitsmediums eingeprägt wird.

Vorteilhafte Ausgestaltungen und Weiterbildungen der Erfindung gehen aus den von den Ansprüchen 1 und 14 abhängigen Ansprüchen sowie der folgenden Beschreibung hervor. Dabei können die beschriebenen Ausgestaltungen des elektrischen Moduls auch bei der Kühlvorrichtung und dem Betriebsverfahren realisiert werden, und umgekehrt.

So kann wenigstens eines der im elektrischen Modul vorhandenen elektrischen Bauelemente ein Halbleiterbauelement sein. Bei dem Modul handelt sich dann insbesondere um ein elektronisches Modul. Es können generell mehrere solche aktiven Bauelemente darin enthalten sein, insbesondere Halbleiterchips mit integrierten Schaltkreisen, sowie zusätzlich auch passive Bauelemente wie Kondensatoren und Widerstände. All diese elektrischen Bauelemente setzen beim Betrieb Wärme aufgrund von Verlustleistungen frei, und diese Wärme kann mit der erfindungsgemäßen Ausgestaltung der Kühlvorrichtung besonders einfach und wirksam abgeführt bzw. zumindest räumlich verteilt (gespreizt) werden.

Das elektrische Modul kann vorteilhaft als leistungselektronisches Modul und insbesondere als Stromrichtermodul ausgestaltet sein. Unter einem Stromrichtermodul wird hier ein elektrisches Gerät verstanden, das zur Umwandlung eines Eingangsstroms in einen Ausgangsstrom unter Änderung wenigstens eines Parameters ausgelegt ist. Es kann sich also insgesamt um ein elektrisches Modul mit der Funktion eines Gleichrichters zur Umwandlung von Wechselstrom in Gleichstrom, eines Wechselrichters zur Umwandlung von Gleichstrom in Wechselstrom, eines Gleichspannungswandlers (DC/DC-Wandler) zur Umwandlung von Gleichstrom in einen andersartigen Gleichstrom oder eines Umrichters (AC/AC-Konverters) zur Umwandlung von Wechselstrom in einen andersartigen Wechselstrom handeln. Diese Umwandlung erfolgt insbesondere mittels elektronischer Bauelemente auf der Basis von Halbleitermaterialien, den sogenannten Leistungshalbleitern. Diese weisen beim Betrieb typischerweise eine besonders hohe Verlustleistung auf, so dass für eine effektive Kühlung auch ein gewisser zusätzlicher Herstellungsaufwand für die erfindungsgemäß ausgestalteten Strukturen in Kauf genommen werden kann.

Gemäß einer allgemein vorteilhaften Ausgestaltung des Kühlsystems sind die Kaltsegmente der Kanalwand jeweils im Bereich eines zugeordneten Kühlelements angeordnet, insbesondere mit gleicher axialer Position und/oder axialer räumlicher Überlappung. Dabei können insgesamt auch mehrere solche Kühlelemente vorliegen. Das jeweilige Kühlelement ist thermisch so mit ein oder mehreren zugeordneten Kaltsegmenten gekoppelt, dass eine Entwärmung des durch den Medienkanal strömenden fluiden Arbeitsmediums ermöglicht wird. Dabei findet ein Wärmeeintrag aus dem Arbeitsmedium in das Kühlelement über die jeweils zugeordneten Kaltsegmente der Kanalwand statt. Das Kühlelement kann prinzipiell unterschiedlich ausgestaltet sein. Wesentlich ist nur, dass es eine Entwärmung des Arbeitsmediums ermöglicht, so dass insgesamt eine Wärmespreizung der Verlustwärme und eine Kühlung der elektrischen Bauelemente erreicht wird. Insbesondere kann das wenigstens eine Kühlelement zur Entwärmung an die äußere Umgebung des elektrischen Moduls ausgelegt sein. Dabei können verschiedene sekundäre Kühlmechanismen zum Einsatz kommen.

Gemäß einer ersten Ausführungsvariante kann das Kühlelement als Kühlkörper ausgestaltet sein, welcher insbesondere auf einer von dem Medienkanal abgewandten Seite eine oberflächenvergrößernde Struktur aufweist. Diese Struktur vergrößert die Oberfläche im Vergleich zu einer ebenen Oberfläche und bewirkt so eine Erhöhung der Wärmeabgabe des Kühlkörpers an die Umgebung, beispielsweise an eine Umgebungsluft oder ein weiteres, den Kühlkörper anströmendes fluides Kühlmedium. Die oberflächenvergrößernde Struktur kann insbesondere eine Mehrzahl von Kühlrippen aufweisen bzw. aus solchen Kühlrippen bestehen. Alternativ oder zusätzlich können auch andere oberflächenvergrößernde Strukturen wie Kühlsterne, Kühlfahnen, Kühlsäulen und/oder sogenannte Pin Fins zum Einsatz kommen.

Gemäß einer zweiten Ausführungsvariante kann das wenigstens eine Kühlelement auch eine einfache metallische Durchführung sein. Eine solche metallische Durchführung kann beispielsweise ein längliches Element sein und auf eine von dem Bauelement abgewandte Seite einer in dem elektrischen Modul enthaltenen Leiterplatte führen. Solche Durchführungen werden in der Elektrotechnik häufig als "Vias" bezeichnet und können bei einer thermischen Ankopplung an die Kaltsegmente der Kanalwand ebenfalls zur Wärmespreizung genutzt werden. Vorteilhaft liegt dabei eine Mehrzahl von metallischen Durchführungen vor, welche z.B. jeweils ein oder mehreren Kaltsegmenten zugeordnet sein können und thermisch mit diesen gekoppelt sein können.

Gemäß einer dritten Ausführungsvariante kann das Kühlelement das thermisch koppelnde Element eines Wärmeübertragers sein. Solche Wärmeübertrager werden manchmal auch als Wärmetauscher bezeichnet und ermöglichen die Übertragung von thermischer Energie von einem Stoffstrom auf einen anderen, hier also von dem fluiden Arbeitsmedium des beschriebenen Medienkanals auf ein weiteres fluides Kühlmedium. Dieses weitere fluide Kühlmedium kann eine von dem Medienkanal abgewandte Seite des Kühlelements anströmen und prinzipiell in einem geschlossenen Kreislauf zirkulieren oder in einer offenen Strömung dort entlanggeführt werden. Der Wärmeübertrager kann beispielsweise zu einem Betrieb nach dem Gegenstromprinzip, nach dem Gleichstromprinzip oder nach dem Kreuzstromprinzip ausgelegt sein.

Allgemein und unabhängig von der genauen Ausführung des Kühlelements kann die thermische Kopplung mit dem zugeordneten Kaltsegment (oder einer Mehrzahl von zugeordneten Kaltsegmenten) entweder durch einen direkten Kontakt mit dem Kaltsegment der Kanalwand oder über ein dünnes, hochwärmeleitendes Zwischenelement erfolgen, analog wie bei der Ankopplung der Warmsegmente an das elektrische Bauelement. Weiterhin können die vorliegenden Kühlelemente allgemein vorteilhaft aus einem metallischen Material gebildet sein.

Bei einem betriebsbereiten Zustand des elektrischen Moduls kann der längliche Medienkanal allgemein vorteilhaft mit einem fluiden Arbeitsmedium befüllt sein. Der Medienkanal kann dabei insbesondere fluiddicht gegen die äußere Umgebung gekapselt sein, so dass das Arbeitsmedium in einem geschlossenen Medienkreislauf zirkuliert. Vorteilhafte Arbeitsmedien sind beispielsweise Aceton, Ammoniak, Ethanol oder Wasser. Das Arbeitsmedium ist "fluid" in dem Sinne, dass es sich in einem flüssigen, gasförmigen oder überkritischen Aggregatszustand befindet. Bevorzugt liegt das Arbeitsmedium bei einer Betriebstemperatur des Moduls in einem einphasigen Zustand vor, insbesondere in einem flüssigen oder gasförmigen Aggregatszustand.

Ein flüssiger Stoffstrom ist dabei vorteilhaft, um einen besonders niedrigen Wärmewiderstand zu erreichen. Auch ein gasförmiger Stoffstrom kann jedoch Vorteile in Bezug auf den thermischen Ausdehnungskoeffizienten und/oder die selbsttätige Ausbildung einer thermisch induzierten Strömung aufweisen.

Allgemein bevorzugt weist das Arbeitsmedium einen volumetrischen thermischen Ausdehnungskoeffizienten von wenigstens 200 · 10⁻⁶ K⁻¹ auf. Der thermische Ausdehnungskoeffizient des Arbeitsmediums liegt dabei insbesondere um wenigstens einen Faktor zwei höher als ein thermischer Ausdehnungskoeffizient eines Materials der Kanalwand. Besonders vorteilhaft ist der Faktor sogar wenigstens 10 und insbesondere sogar wenigstens 50. So kann der volumetrische thermische Ausdehnungskoeffizient der Kanalwand beispielsweise bei höchstens 100 · 10⁻⁶ K⁻¹ liegen. Gemäß einem günstigen Materialbeispiel kann die Kanalwand aus Aluminium mit einem linearen thermischen Ausdehnungskoeffizienten von etwa 23 · 10⁻⁶ K⁻¹ gebildet sein, und das Arbeitsmedium kann Aceton mit einem linearen thermischen Ausdehnungskoeffizienten von etwa 1460 · 10⁻⁶ K⁻¹ sein. Dabei liegt der volumetrische Ausdehnungskoeffizient in etwa bei dem Dreifachen der angegebenen linearen Ausdehnungskoeffizienten. Die angegebenen Werte beziehen sich jeweils auf Temperaturen im Bereich der Raumtemperatur, wobei die Betriebstemperatur des Medienkanals allgemein auch davon abweichen und insbesondere höher sein kann. Die Wahl eines Arbeitsmediums mit einem im Vergleich zur Kanalwand höheren Ausdehnungskoeffizienten ist vorteilhaft, um einen durch den lokalen Wärmeeintrag im Bereich der Warmsegmente induzierten Längstransport des Kühlmediums zu fördern. Wenn sich die Kanalwand aufgrund des Wärmeeintrags weniger stark ausdehnt als das von ihr umschlossene Arbeitsmedium, ergibt sich im jeweiligen Warmsegment ein lokaler Überdruck, der den Stofftransport in Richtung eines benachbarten Kaltsegments antreiben kann. Wenn der Faktor zwischen den thermischen Ausdehnungskoeffizienten vergleichsweise hoch ist und die Elastizität der Kanalwand gering ist, kann die umgebende Kanalwand als annähernd starr im Vergleich zu dem sich ausdehnenden Arbeitsmedium in ihrem Inneren betrachtet werden.

Allgemein vorteilhaft weist das fluide Arbeitsmedium eine Wärmeleitfähigkeit von wenigstens 0,1 W/(m K) auf. Ein Wert in diesem Bereich wird durch viele Flüssigkeiten, aber auch durch ausgewählte Gase erreicht. Eine vergleichsweise hohe Wärmeleitfähigkeit ist allgemein bevorzugt, um einen geringen Wärmewiderstand über den Medienkanal zu erreichen. Da der wesentliche Wärmetransport jedoch durch die thermisch induzierte Strömung zustande kommt und nicht nur durch Wärmeleitung, können auch Arbeitsmedien mit niedrigeren Wärmeleitfähigkeiten, beispielsweise im Bereich zwischen 0,01 W/(m K) und 0,1 W/(m K) zum Einsatz kommen.

Weiterhin ist es bevorzugt, wenn die Kanalwand aus einem Material mit einer Wärmeleitfähigkeit von wenigstens 1 W/(m K) gebildet ist. Dies kann sich prinzipiell auf die Warmsegmente und auf die Kaltsegmente der Kanalwand beziehen, welche vorteilhaft mit einem insgesamt einheitlichen Material der Kanalwand gebildet sind. Auch eine Wanddicke der Kanalwand kann insgesamt einheitlich gewählt sein und beispielsweise in einem Bereich zwischen 0,1 mm und 3 mm liegen. Eine derart ausgestaltete Kanalwand ermöglicht einen effektiven Wärmeeintrag von dem elektrischen Bauelement in das Innere des Medienkanals und/oder eine effektive Entwärmung von dem Arbeitsmedium in das optional an die Kaltsegmente angekoppelte Kühlelement. Grundsätzlich muss die Kanalwand jedoch nicht mit einer einheitlichen Dicke ausgebildet sein, insbesondere kann der Medienkanal auch als komplexe, mäanderartige Struktur innerhalb eines (ansonsten massiven) Körpers definiert sein. Der oben angegebene vorteilhafte Bereich für die Wanddicke ist dann jedoch trotzdem auf den vorteilhaften Höchstabstand zwischen dem innenliegenden Arbeitsmedium und dem außenliegenden zu entwärmenden Element bzw. dem Kühlelement anwendbar.

Gemäß einer weiteren bevorzugten Ausführungsform kann die Kanalwand mit einem auxetischen Material gebildet sein. Ein auxetisches Material ist durch eine negative Querkontraktionszahl (Poissonzahl) gekennzeichnet, so dass es sich bei einer Streckung quer zur Streckrichtung ausdehnt. Durch diesen Effekt kann ein lokaler Wärmeeintrag aufgrund einer resultierenden Längs-Streckung der Kanalwand zu einer lokalen Einengung des innenliegenden Medienkanals führen oder zumindest zu einer Verringerung der ohne diesen Effekt aus dem Wärmeeintrag resultierenden thermischen Ausdehnung des Innendurchmessers. Ein auxetisches Material kann durch solch eine "relative Verengung" des Medienkanals dazu beitragen, den thermisch induzierten axialen Stofftransport zusätzlich zu fördern.

Die miteinander abwechselnden Warmsegmente und Kaltsegmente können bezüglich ihrer lokalen Längsrichtung jeweils eine Segmentlänge aufweisen, welche in einem Bereich zwischen 1 mm und 10 mm liegt. Insbesondere kann die Segmentlänge der einzelnen Warmsegmente untereinander gleich sein, und auch die Segmentlänge der einzelnen Kaltsegmente kann untereinander gleich sein. Weiterhin können die Kaltsegmente die gleiche Segmentlänge aufweisen wie die dazwischenliegenden Warmsegmente. Die entsprechende Länge der dazwischenliegenden Übergangsbereiche kann dabei vergleichsweise kurz sein und z.B. nur einen Bruchteil der Segmentlänge der Warm- und/oder Kaltsegmente betragen. Entsprechend kann eine räumliche Wiederholungslänge für eine sich periodisch wiederholende Abfolge aus einem Warmsegment, einem Übergangsbereich, einem Kaltsegment und einem weiteren Übergangsbereich vorteilhaft in einem Bereich zwischen 2 mm und 25 mm liegen.

Die Gesamtzahl der Warmsegmente kann insbesondere gleich der Gesamtzahl der Kaltsegmente sein, dies ist jedoch nicht zwingend erforderlich, und die regelmäßige Anordnung aus miteinander abwechselnden Warm- und Kaltsegmenten kann beispielsweise auch Lücken aufweisen, in denen einzelne Warm- bzw. Kaltsegmente fehlen. Vorteilhaft wird jedoch durch solche Lücken die räumliche Wiederholungslänge einer wiederkehrenden räumlichen Abfolge nicht unterbrochen, sondern es ist lediglich ein Warm- oder Kaltsegment durch ein sogenanntes neutrales Zwischensegment ersetzt, welches für das Innere des Medienkanals weder eine Wärmequelle noch eine Wärmesenke darstellt.

Allgemein kann auch ein vergleichsweise größerer Teilbereich der Kanalwand als ein solches neutrales Zwischensegment ausgebildet sein, welches entsprechend ein Paar aus zwei Warmsegmenten, ein Paar aus zwei Kaltsegmenten oder ein Paar aus einem Kalt- und einem Warmsegment räumlich miteinander verbindet. Dabei kann die Segmentlänge des neutralen Zwischenelements insbesondere größer sein als die mittlere Segmentlänge der einzelnen Warm- und Kaltsegmente. Bevorzugt ist es in einem solchen Fall, wenn die Segmentlänge des Zwischensegments so gewählt ist, dass sie einem Vielfachen der räumlichen Wiederholungslänge einer periodisch wiederkehrenden Abfolge aus nebeneinanderliegenden Warm- und Kaltsegmenten entspricht, so dass die periodische Abfolge nur unterbrochen, aber nicht gestört wird. Dann kann ein thermisch induzierter Medientransport besonders effektiv in das neutrale Zwischensegment propagieren, und es kann sich über den gesamten ringförmig geschlossenen Medienkanal ein pulsierender Medientransport einstellen, ohne dass die Frequenz dieses pulsierenden Medientransports durch das neutrale Zwischensegment gestört ist. Es können auch mehrere neutrale Zwischensegmente vorliegen. Allgemein ist es jedoch bevorzugt, wenn wenigstens 50% der Längsausdehnung des Medienkanals durch die beschriebenen Warm- und Kaltsegmente abgedeckt ist, um mit den resultierenden Temperaturunterschieden einen effektiven Medientransport entlang der Längsrichtung des Kanals antreiben zu können.

Gemäß einer allgemein vorteilhaften Ausführung kann der längliche Medienkanal eine Kanalbreite in einem Bereich zwischen 0,1 mm und 4 mm aufweisen. Beispielsweise kann der Medienkanal einen kreisförmigen Querschnitt aufweisen, und der Kanaldurchmesser kann in diesem Bereich liegen. Alternativ kann der Kanal auch einen rechteckigen Querschnitt oder eine andere Querschnittsform aufweisen, und sowohl die kleinste als auch die größte Ausdehnung des Medienkanals (in Querrichtung) kann in dem genannten Bereich liegen. Die Querschnittsfläche des Medienkanals kann entsprechend vorteilhaft in einem Bereich zwischen 0,01 mm² und 16 mm² liegen. Eine solche Dimensionierung des Kanalquerschnitts ist allgemein vorteilhaft, um einerseits eine effektive Wärmeübertragung zwischen den Warmsegmenten und Kaltsegmenten zu gewährleisten und andererseits den mit der Fertigung des Medienkanals verbundenen Fertigungsaufwand in vertretbaren Grenzen zu halten. Insbesondere ist eine besonders präzise Einhaltung einer vorgegebenen Geometrie dabei nicht notwendig. Die Form und die Größe des Kanalquerschnitts kann beispielsweise über die Länge des Medienkanals im Wesentlichen konstant sein, wobei fertigungsbedingte oder designbedingte lokale Abweichungen in der Form und Größe keine wesentlichen negativen Auswirkungen haben.

Für das wenigstens ein strömungsleitendes Element bzw. die Mehrzahl an strömungsleitenden Elementen sind unterschiedliche Ausführungsvarianten denkbar. So kann gemäß einer ersten Ausführungsform ein strömungsleitendes Element durch eine schräg zur lokalen Längsrichtung ausgerichtete Lamelle ausgebildet sein. Eine solche Lamelle kann aus demselben Material wie die Kanalwand gebildet sein und insbesondere einstückig mit der Kanalwand gebildet sein. Beispielsweise können solche Lamellen paarweise gegenüberliegend an Teilbereichen der Kanalwand ausgebildet sein, z.B. können sie oberhalb und unterhalb bzw. rechts und links einer Hauptströmung des Arbeitsmediums liegen. Solche Strömungslamellen können durch ihre schräge Anordnung dazu beitragen, eine Vorzugsrichtung in den Medienstrom einzuprägen. Sie können als starre Lamellen ausgestaltet sein oder alternativ auch aus einem flexiblen Material (wie einem dünnen Metall oder einem Kunststoff) gebildet sein. Durch eine flexible Ausführung kann ein pulsierender Medienstrom entlang einer Vorzugsrichtung besonders effektiv gefördert werden, da die Lamellen dann nach Art eines Rückschlagventils wirken können.

Alternativ zu solchen (einzelnen oder paarweise angeordneten) Lamellen können die Übergangsbereiche auch ein oder mehrere Düsen zur Ausprägung einer Vorzugsrichtung aufweisen. Im Bereich einer solchen Düse kann sich Querschnitt des innenliegenden Medienkanals insgesamt (symmetrisch oder asymmetrisch) entlang der Vorzugsrichtung verengen.

Ganz allgemein kann das strömungsleitende Element als Rückschlagventil ausgestaltet sein, also als Ventil, welches eine Strömung des Arbeitsmediums überwiegend in eine Richtung zulässt. Hierzu kann das Rückschlagventil ein oder mehrere bewegliche Teile aufweisen, also eine flexible Rückschlagklappe wie beim menschlichen Herzen oder eine ähnliche rückflusshemmende Struktur. Die Sperrwirkung muss in der Rückrichtung jedoch nicht vollständig ein und es reicht für die Ausprägung einer Vorzugsrichtung z.B. schon aus, wenn das Rückschlagventil einen Rückstrom im Vergleich zu einem Vorwärtsstrom um einige Prozent bis einige zehn Prozent verringert. Vor allem wenn insgesamt eine Vielzahl von Rückschlagventilen in dem Medienkanal angeordnet ist, kann dem Medienstrom trotzdem wirksam eine Vorzugsrichtung eingeprägt werden. Dies gilt analog auch für die anderen Arten von strömungsleitenden Elementen.

Ein weiteres geeignetes strömungsleitendes Element ist ein Teslaventil, welches funktionell eine passive Variante eines Rückschlagventils ohne bewegliche Teile darstellt. Durch die Einbringung einer zusätzlichen Schlaufe in einen insgesamt länglichen Medienkanal kann durch eine geeignete Formgebung im Bereich der Verzweigung und des Zusammenflusses eine Richtungsabhängigkeit des ausgebildeten Strömungswiderstands erreicht werden.

Gemäß einer weiteren Ausgestaltung der Erfindung kann die Kanalwand im Bereich wenigstens eines Warmsegments eine lokale Ausnehmung aufweisen, durch welche das elektrische Bauelements unmittelbar von dem fluiden Arbeitsmedium anströmbar ist. Insbesondere kann ein elektrisch aktives Teilelement des elektrischen Bauelements, also insbesondere ein Halbleitermaterial, ein Elektrodenmaterial und/oder ein Leitermaterial eines elektrischen Widerstands von dem Arbeitsmedium direkt anströmbar sein. Bei dieser direkten Ankopplung einer Wärmequelle an das Arbeitsmedium wird eine noch effektivere Entwärmung des elektrischen Bauelements erreicht. Zweckmäßig ist das Arbeitsmedium dann aus einem elektrisch isolierenden Stoff gebildet, um eine unerwünschte elektrische Kontaktierung des Bauelements über das Arbeitsmedium zu vermeiden. Alternativ oder zusätzlich kann auch ein optional vorhandenes Kühlelement durch ein oder mehrere lokale Ausnehmungen im zugeordneten Kaltsegment der Kanalwand direkt von dem fluiden Arbeitsmedium anströmbar sein. So kann in analoger Weise ein noch effektiverer Wärmeeintrag in dieses Kühlelement bewirkt werden.

Gemäß einer weiteren allgemein bevorzugten Ausführungsform kann das fluide Arbeitsmedium beim Betrieb des elektrischen Moduls bzw. der Kühlvorrichtung einen einphasigen Stoffstrom ausbilden. Im Gegensatz zu einer pulsierenden Heatpipe findet also keine abwechselnde Verdampfung und Kondensation statt. Die Verdampfungsenthalpie kann dann zwar nicht für die Wärmeübertragung genutzt werden, aber es ergeben sich geringere Anforderungen an die geometrische Präzision bei der Ausbildung der Geometrie des Medienkanals. Durch das Ausbilden eines stabilen Medienstroms mit einer ausgeprägten Vorzugsrichtung kann trotzdem ein vergleichsweise niedriger Wärmewiderstand zwischen den Warmsegmenten und den Kaltsegmenten der Kanalwand erreicht werden. Außerdem ist der Stofftransport und damit auch der Wärmetransport in einem einphasigen System weniger durch lokale Dichteunterschiede beeinflusst. Dadurch ist der Stofftransport auch weniger von der räumlichen Orientierung im Schwerefeld abhängig. Weiterhin können bei einem einphasigen System andere Arbeitsmedien verwendet werden, und die Auswahl geeigneter Stoffe ist unter Umständen freier.

Nachfolgend wird die Erfindung anhand einiger bevorzugter Ausführungsbeispiele unter Bezugnahme auf die angehängten Zeichnungen beschrieben, in denen:
Figur 1 eine schematische Schnittdarstellung einer Kühlvorrichtung zeigt,
Figur 2 drei verschiedene Betriebsstadien einer solchen Kühlvorrichtung zeigt,
Figur 3 eine schematische Aufsicht eines elektrischen Moduls zeigt und
Figur 4 eine Prinzipdarstellung für die Propagation eines thermisch angetriebenen Medientransports zeigt.

In den Figuren sind gleiche oder funktionsgleiche Elemente mit gleichen Bezugszeichen versehen.

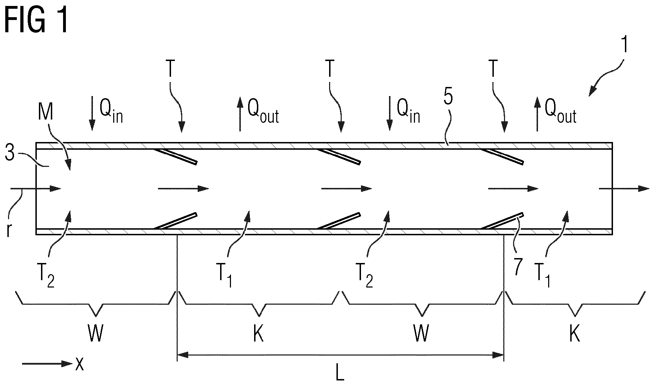

In Figur 1 ist ein Teilbereich einer Kühlvorrichtung 1 im schematischen Längsschnitt gezeigt. Gezeigt ist ein Ausschnitt aus einem insgesamt länglichen Medienkanal 3, der durch eine Kanalwand 5 begrenzt ist. Der gezeigte Ausschnitt ist ein Teilbereich eines insgesamt ringförmig geschlossenen Medienkanals 3, in welchem ein fluides Arbeitsmedium M in einem geschlossenen Kreislauf zirkulieren kann. Innerhalb des Medienkanals 3 befindet sich also das fluide Arbeitsmedium M, das beispielsweise eine Flüssigkeit sein kann. Ein geeignetes Arbeitsmedium M ist z.B. Aceton. Der gezeigte Abschnitt des Medienkanals 3 weist eine lokale Längsrichtung auf, die hier mit x bezeichnet ist und auch als axiale Richtung bezeichnet wird. Der Medienkanal 3 muss dabei nicht rotationssymmetrisch geformt sein, und es sind neben einem kreisförmigen Querschnitt auch andere, z.B. rechteckige Querschnittsformen mit oder ohne abgerundete Ecken denkbar.

Der Medienkanal 3 ist ringsum durch eine Kanalwand 5 begrenzt, die aus einem vergleichsweise hochwärmeleitenden Material und insbesondere aus einem metallischen Material gebildet sein kann. Ein geeignetes Material ist z.B. Aluminium oder eine aluminiumbasierte Legierung. Die Kanalwand 5 ist in ihrer lokalen Längsrichtung x in miteinander abwechselnde Warmsegmente W und Kaltsegmente K unterteilt. Die dazwischenliegenden Übergangsbereiche sind mit T gekennzeichnet. Dabei müssen die Warmsegmente W also nicht (wie hier skizziert) unmittelbar an die benachbarten Kaltsegmente K angrenzen, sondern es kann auch eine gewisse Lücke zwischen diesen Längssegmenten vorgesehen sein. Die einzelnen Warm- und Kaltsegmente W, K müssen auch nicht durch klare Grenzen voneinander getrennt sein. Sie unterscheiden sich vor allem darin, dass die einzelnen Warmsegmente W ein oder mehreren zu entwärmenden Elementen zugeordnet sind und thermisch mit diesen gekoppelt sind. Diese zu entwärmenden Elemente sind hier nicht näher dargestellt, sondern nur durch den von ihnen ausgehenden Wärmeeintrag Qᵢₙ repräsentiert. Ein solches zu entwärmendes Element kann insbesondere ein elektrisches Bauelement wie z.B. ein Halbleiterbauelement, ein elektrischer Widerstand oder ähnliches sein. Ein solches Bauelement kann insbesondere im Bereich eines Warmsegments W unmittelbar in Kontakt mit der Kanalwand 5 stehen, oder über ein dünnes, hochwärmeleitendes Zwischenelement (wie z.B. einer metallischen Trägerplatte) thermisch mit der Kanalwand 5 gekoppelt sein. Insbesondere weist das zu entwärmende Element in x-Richtung eine gleiche oder zumindest überlappende Position auf wie das zugeordnete Warmsegment W. Der Abstand zwischen dem Warmsegment W der Kanalwand 5 und dem jeweils zugeordneten zu entwärmenden Element kann beispielsweise unterhalb von 2 mm liegen, um eine möglichst enge thermische Ankopplung zu bewirken.

In analoger Weise sind die einzelnen Kaltsegmente K ein oder mehreren Kühlelementen zugeordnet, die als Wärmesenken in der Kühlvorrichtung fungieren. Auch diese Kühlelemente sind hier nicht näher dargestellt, sondern nur durch den aus dem jeweiligen Kaltsegment K in sie ausgebrachten Wärmeaustrag Qₒᵤₜ repräsentiert. Ein solches Kühlelement kann beispielsweise ein Kühlkörper mit Kühlrippen zur Entwärmung an eine Umgebungsluft sein oder ein Wärmeübertrager mit einem sekundären Kühlmedium oder eine pulsierende Heatpipe oder eine andere Art von Kühlelement mit einem sekundären Kühlmechanismus zur Abfuhr von Wärme aus dem Bereich des Medienkanals 3. Die Positionierung des jeweiligen Kühlelements relativ zu dem zugeordneten Kaltsegment K, die thermische Ankopplung und der Abstand kann analog ausgestaltet sein wie oben im Zusammenhang mit den Warmsegmenten W und den zugeordneten zu entwärmenden Elementen beschrieben. Insbesondere ist jedem Warmsegment W wenigstens ein zu entwärmendes Element zugeordnet, und jedem Kaltsegment K ist wenigstens ein Kühlelement zugeordnet.

Durch die miteinander wechselnde Abfolge aus Warmsegmenten W und benachbarten Kaltsegmenten K ist insgesamt ein regelmäßiges Muster mit einer räumlichen Wiederholungslänge L gebildet. Diese regelmäßige Abfolge muss sich nicht über die gesamte Länge des Medienkanals 3 erstrecken, aber zumindest über einen Teilbereich. Vorteilhaft ist eine solche regelmäßige Abfolge auf einem überwiegenden Teil seiner Gesamtlänge ausgebildet.

In den Übergangsbereichen T, die im Grenzbereich zwischen den benachbarten Warmsegmenten W und Kaltsegmenten K liegen, sind hier jeweils strömungsleitende Elemente 7 angeordnet. Im gezeigten Beispiel sind dies insbesondere Leitlamellen 7, welche sich im jeweiligen Übergangsbereich paarweise gegenüberliegen. Diese Leitlamellen 7 können insbesondere aus demselben Material wie die übrige Kanalwand 5 gebildet sein und einstückig in diese übergehen. Alternativ können sie jedoch auch aus einem anderen Material gebildet sein. Sie können beispielsweise durch Ätzen, Fräsen, Spritzgießen, mechanisches Umformen durch Presswerkzeuge und/oder ein additives Herstellungsverfahren gebildet sein.

Die strömungsleitenden Elemente 7 können insbesondere in einer Mehrzahl von solchen Übergangsbereichen T und besonders bevorzugt in allen derartigen Übergangsbereichen T innerhalb der regelmäßigen Abfolge angeordnet sein. Sie dienen dazu, einer innerhalb des Medienkanals 3 ausgebildeten Strömung des fluiden Arbeitsmediums M eine Vorzugsrichtung r einzuprägen. Der Strömungswiderstand durch den Übergangsbereich ist also entlang der Vorzugsrichtung r geringer als in der Gegenrichtung. Hierdurch kann sich ein übergeordneter Netto-Stoffstrom des Arbeitsmediums in dem geschlossenen Medienkreislauf entlang der Vorzugsrichtung r ausbilden.

Durch den regelmäßigen Wechsel aus Warmsegmenten W und Kaltsegmenten K wird eine thermisch induzierte Ausbildung eines solchen Stoffstroms gefördert. Insbesondere werden für einen solchen thermisch induzierten Stoffstrom keine Pumpen oder sonstigen aktiven Antriebsmittel benötigt. Die treibende Kraft für einen solchen selbsttätig ausgebildeten Stoffstrom liegt in den Temperaturdifferenzen zwischen den Abschnitten des Medienkanals 3, die innerhalb der Warmsegmente W und der Kaltsegmente K liegen. Dabei ist die Temperatur des Arbeitsmediums M innerhalb eines Kaltsegments K hier mit T₁ und die Temperatur des Arbeitsmediums M innerhalb eines Warmsegmentes M hier mit T₂ bezeichnet.

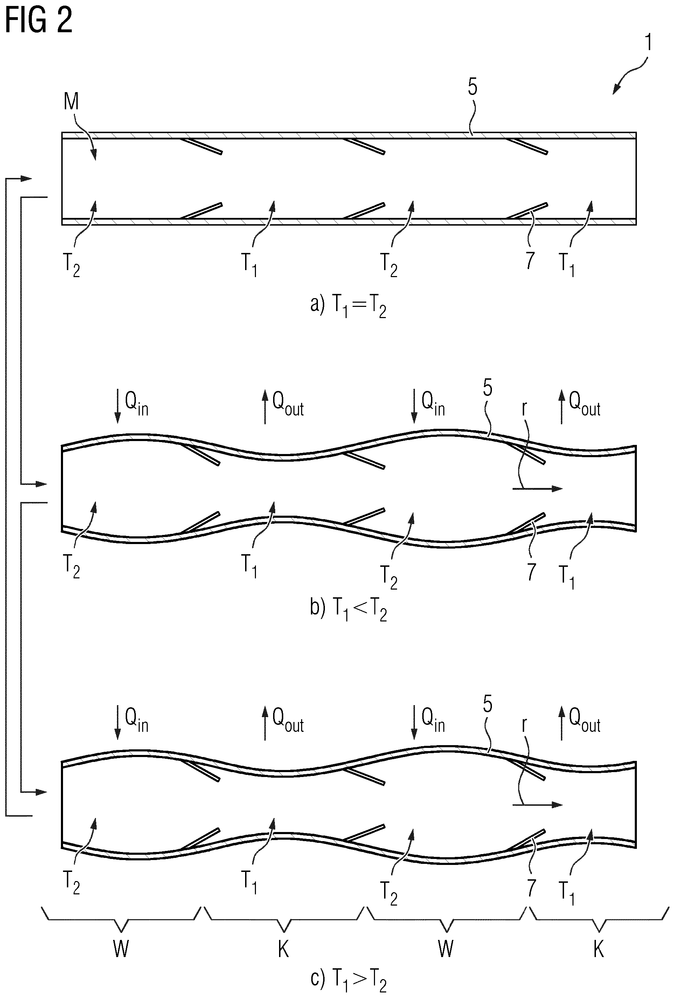

Figur 2 zeigt eine schematische Skizze für drei verschiedene Betriebsstadien a) bis c) einer solchen Kühlvorrichtung 1, um die selbsttätige Ausbildung des Stoffstroms entlang der Vorzugsrichtung r zu verdeutlichen. Im ersten Stadium a) sind die Temperaturen T₁ und T₂ im Wesentlichen gleich. Dies entspricht also einem Ausgangsstadium, bevor die Wärmeflüsse Qᵢₙ und Qₒᵤₜ begonnen haben und bevor der Stofftransport eingesetzt hat. Im darauffolgenden Stadium b) hat bereits ein Wärmeeintrag Qᵢₙ in das Arbeitsmedium M über die Warmsegmente W der Kanalwand 5 und ein Wärmeaustrag Qₒᵤₜ aus dem Arbeitsmedium über die Kaltsegmente K stattgefunden. Hierdurch ist die Temperatur T₂ innerhalb der Warmsegmente W höher als die Temperatur T₁ innerhalb der Kaltsegmente K. Dies führt im Bereich der Warmsegmente W zu einer thermischen Expansion sowohl der Kanalwand 5 als auch des innenliegenden Arbeitsmediums M. Wenn der thermische Expansionskoeffizient des Arbeitsmediums M höher ist als derjenige des Materials der Kanalwand, dann dehnt sich das Innere des Medienkanals hier stärker aus als die umgebende Kanalwand 5, was in Figur 2 beim Stadium b) durch eine konvexe Auswölbung in diesem Bereich gekennzeichnet ist. Diese Auswölbung ist jedoch stark übertrieben dargestellt und symbolisiert vor allem den lokalen Druckanstieg im Inneren des Medienkanals 3 im Bereich der Warmsegmente W. Insbesondere ist der Mediendruck im Bereich der Warmsegmente W in diesem Bereich höher als im Bereich der benachbarten Kaltsegmente K. Um diesen Druckunterscheid auszugleichen, kann das Arbeitsmedium M von einem gegebenen Warmsegment prinzipiell nach rechts oder links strömen. Die strömungsleitenden Elemente 7 begünstigen jedoch den Medienfluss nach rechts, entlang der Vorzugsrichtung r. Daher stellt sich insgesamt als Ausgleichsbewegung eine Netto-Strömung des Arbeitsmediums M in dieser Richtung ein.

Im unteren Teil der Figur 2 ist ein darauffolgendes Betriebsstadium c) gezeigt, bei welchem das Arbeitsmedium M innerhalb des ringförmigen Medienkanals netto insgesamt um die Hälfte der Widerholungslänge L weitertransportiert wurde. Durch diesen ringförmigen Transport ist in diesem Stadium die Temperatur T₂ innerhalb der Warmsegmente W jetzt niedriger als die Temperatur T₁ innerhalb der Kaltsegmente K. Die Temperaturverteilung des Stadiums b) ist also in etwa invertiert. Aufgrund dieser umgekehrten Temperaturverhältnisse kann nun ein wesentlich effektiver Wärmeeintrag Qᵢₙ in die Warmsegmente W und ein effektiverer Wärmeaustrag Qₒᵤₜ aus den Kaltsegmenten K erfolgen. Der aus der thermisch induzierten Strömung resultierende Medientransport in x-Richtung trägt daher zu einer wirksamen Wärmespreizung in dieser Raumrichtung bei und insgesamt zu einer Reduktion des thermischen Widerstands zwischen dem wenigstens einen zu entwärmenden Element, das thermisch an die Warmsegmente W gekoppelt ist und dem wenigstens einen Kühlelement, das an die Kaltsegmente K gekoppelt ist. So kann insgesamt eine besonders effektive Entwärmung von ein oder mehreren zu entwärmenden Bauelementen bewirkt werden.

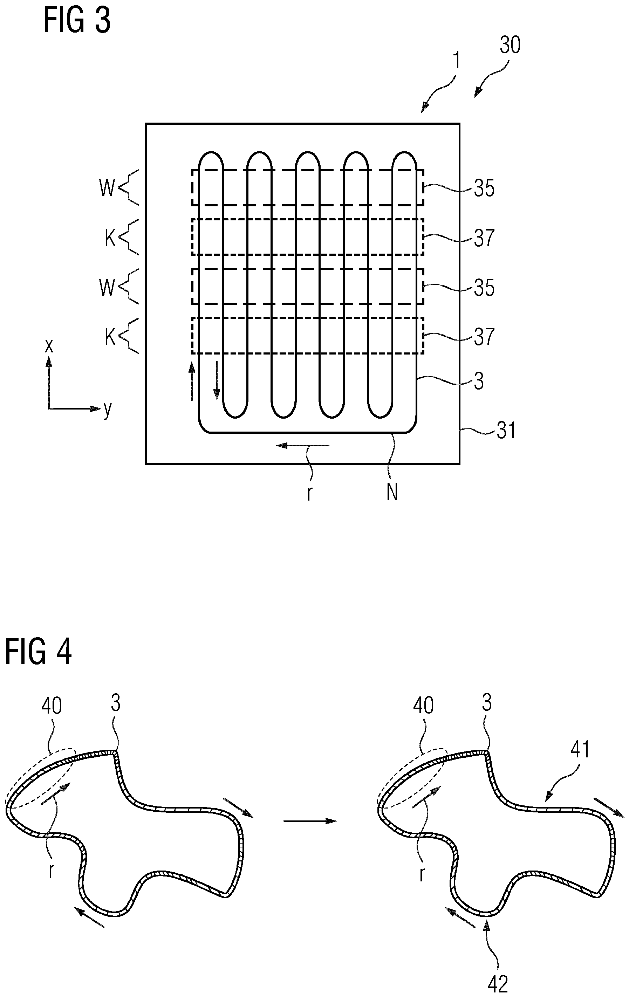

Figur 3 zeigt eine schematische Aufsicht eines elektrischen Moduls 30. Dieses elektrische Modul 30 weist eine flache Trägerplatte 31 auf, auf welcher ein oder mehrere elektrische Bauelemente 35 des Moduls 30 angeordnet sind. Nur beispielhaft sind hier zwei elektrische Bauelemente 35 dargestellt. Außerdem weist das Modul z.B. zwei Kühlelemente 37 auf, welche zur Abgabe von Wärme an die Umgebung ausgestaltet sind.

Zur Entwärmung der Bauelemente 35 weist das Modul 30 ein Kühlsystem 1 auf, welches insgesamt nach dem gleichen Prinzip arbeitet wie vorab im Zusammenhang mit den Figuren 1 und 2 beschrieben. Gezeigt ist eine Aufsicht auf die xy-Ebene, welche eine flache mäanderartige Struktur eines ringförmigen Medienkanals 3 enthält, der in der Hauptebene der Trägerplatte 31 liegt. Der Medienkanal 3 ist also durch eine Ausnehmung in der Trägerplatte gebildet. Die elektrischen Bauelemente 35 und die Kühlelemente 37 können dabei prinzipiell oberhalb und/oder unterhalb der Zeichnungsebene (also der Ebene des mäanderförmigen Medienkanals) angeordnet sein. Sie sind in dieser Aufsicht nur der Übersichtlichkeit halber zusammen mit den übrigen Elementen dargestellt, und die gestrichelten Umrandungen verdeutlichen die unterschiedliche Lage bezüglich der hier nicht gezeigten z-Richtung. Dabei können die elektrischen Bauelemente 35 beispielsweise bezüglich der z-Richtung auf einer unterschiedlichen Seite der Kanalebene angeordnet sein wie die Kühlelemente 37. Sie können jedoch prinzipiell auch auf derselben Seite liegen (also beide oberhalb oder beide unterhalb der Zeichnungsebene).

Nur beispielhaft sind hier für den Medienkanal 3 fünf mäanderartige Windungen gezeigt, wobei eine tatsächliche Windungszahl in einem realen Modul auch wesentlich höher ausfallen kann. Aus den mäanderartigen Windungen resultiert eine Mehrzahl von zueinander parallelen Längssegmenten, welche in x-Richtung ausgerichtet sind. Jedes dieser Längssegmente weist in diesem Beispiel eine Abfolge aus insgesamt zwei Warmsegmenten W und zwei Kaltsegmenten K auf. Auch hier gilt, dass die Anzahl der einzelnen Segmente W, K innerhalb von einem solchen Längssegment des Medienkanals 3 tatsächlich wesentlich höher sein kann. Wesentlich ist nur, dass insgesamt ein oder mehrere Teilbereiche des Medienkanals 3 vorliegen, in denen eine solche wechselnde Abfolge aus Warmsegmenten W und Kaltsegmenten K ausgebildet ist. In den Übergangsbereichen der benachbarten Segmente sind auch hier strömungsleitende Strukturen an der Kanalwand angeordnet, was in dieser Prinzipskizze nur nicht dargestellt ist. So resultiert insgesamt beim Betrieb des elektrischen Moduls 30 ein thermisch induzierter Stoffstrom entlang der Vorzugsrichtung r, hier z.B. netto im Uhrzeigersinn innerhalb der xy-Ebene.

Die Strömung entlang dieser Vorzugsrichtung r propagiert über den gesamten Medienkanal 3, auch wenn nur Teilbereiche davon von dem regelmäßigen Muster aus miteinander abwechselnden Warmsegmenten W und Kaltsegmenten K erfasst sind. So bildet insbesondere der untere rücklaufende Ast des mäanderartigen Medienkanals 3 ein neutrales Zwischensegment N aus, welches weder einem zu entwärmenden Element 35 noch einem Kühlelement 37 zugeordnet ist. Trotz dieser Unterbrechung der regelmäßigen Abfolge kann die Strömung des Medienstroms von den nebeneinanderliegenden Längssegmenten aus über den gesamten ringförmigen Medienkanal 3 propagieren und sich damit auch in dieses neutrale Zwischensegment N fortsetzen.

In Figur 4 ist nur äußerst schematisch skizziert, wie sich ein thermisch induzierter Medienstrom aus einem Teilbereich 40 über einen übergeordneten ringförmigen Medienkanal 3 fortsetzen kann. So wird im links dargestellten Stadium zunächst in einem Teilbereich 40, der ein wechselndes Muster aus Warm- und Kaltsegmenten aufweist, ein Medientransport entlang der Vorzugsrichtung r induziert. Da sich der Stoffstrom des fluiden Arbeitsmediums M aber über den gesamten ringförmigen Medienkanal 3 fortsetzt und ausgleicht, können sich einzelne Bereiche des Arbeitsmediums mit vergleichsweise hoher lokaler Temperatur und einzelne Bereiche des Arbeitsmediums mit vergleichsweise niedriger lokaler Temperatur auch in weit entfernte Bereiche des Medienkanals 3 fortpflanzen, ohne dass dabei das in dem Teilbereich 40 aufgeprägte Muster verlorengeht. Nur beispielhaft ist hier mit 41 eine lokale Kontraktionszone mit vergleichsweise niedriger Temperatur des Arbeitsmediums bezeichnet und mit 42 ist eine lokale Expansionszone mit vergleichsweise hoher Temperatur des Arbeitsmediums bezeichnet. Beide lokalen Zonen sind im Teilbereich 40 entstanden und haben sich durch den ringförmigen Stoffstrom entlang der Vorzugsrichtung r in weit entfernt liegende Abschnitte des Medienkanals 3 fortgepflanzt.

### Bezugszeichenliste

- 1: Kühlvorrichtung
- 3: länglicher Medienkanal
- 5: Kanalwand
- 7: strömungsleitendes Element (Leitlamelle)
- 30: elektrisches Modul (Stromrichtermodul)
- 31: flache Trägerplatte
- 35: elektrisches Bauelement
- 37: Kühlelement
- 40: Teilbereich des Medienkanals
- 41: Kontraktionszone
- 42: Expansionszone
- a) - c): Stadien des Betriebsverfahrens
- K: Kaltsegment
- L: Wiederholungslänge
- M: Arbeitsmedium
- N: neutrales Zwischensegment
- Qᵢₙ: Wärmeeintrag
- Qₒᵤₜ: Wärmeaustrag (Entwärmung)
- W: Warmsegment
- r: Strömungsrichtung (Vorzugsrichtung)
- T: Übergangsbereich
- T₁: erste Temperatur
- T₂: zweite Temperatur
- x: axiale Richtung (lokale Längsrichtung)
- y: laterale Richtung

## Patentansprüche

1. Elektrisches Modul (30) mit wenigstens einem elektrischen Bauelement (35) und einer Kühlvorrichtung (1) zur Kühlung des elektrischen Bauelements (35),
- wobei die Kühlvorrichtung (1) einen ringförmig geschlossenen länglichen Medienkanal (3) zur Zirkulation eines fluiden Arbeitsmediums (M) in einem geschlossenen Kreislauf aufweist,
- wobei der ringförmig geschlossene Medienkanal (3) durch eine Kanalwand (5) begrenzt ist, welche wenigstens in einem Teilbereich (40) in ihrer lokalen Längsrichtung (x) in eine Mehrzahl von miteinander abwechselnden Warmsegmenten (W) und Kaltsegmenten (K) unterteilt ist,
- wobei die Warmsegmente (W) jeweils im Bereich des wenigstens einen elektrischen Bauelements (35) angeordnet sind und thermisch derart mit diesem gekoppelt sind, dass sie eine Entwärmung des elektrischen Bauelements (35) mittels eines lokalen Wärmeeintrags (Qᵢₙ) in das fluide Arbeitsmedium (M) über das jeweilige Warmsegment (W) der Kanalwand (5) ermöglichen,
- wobei zwischen den einander benachbarten Warmsegmenten (W) und Kaltsegmenten (K) jeweils ein Übergangsbereich (T) gebildet ist,
- und wobei in wenigstens einer Teilmenge dieser Übergangsbereiche (T) jeweils wenigstens ein strömungsleitendes Element (7) angeordnet ist, mit welchem einem durch den lokalen Wärmeeintrag (Qᵢₙ) thermisch angetriebenen Transport des fluiden Arbeitsmediums (M) eine Vorzugsrichtung (r) aufgeprägt werden kann.

2. Elektrisches Modul (30) nach Anspruch 1, bei welchem wenigstens eines der vorliegenden elektrischen Bauelemente (35) ein Halbleiterbauelement ist.

3. Elektrisches Modul (30) nach Anspruch 2, welches als Stromrichtermodul ausgestaltet ist.

4. Elektrisches Modul (30) nach einem der vorhergehenden Ansprüche, bei welchem die Kaltsegmente (K) der Kanalwand (5) jeweils im Bereich eines Kühlelements (37) angeordnet sind und thermisch derart mit diesem gekoppelt sind, dass eine Entwärmung (Qₒᵤₜ) des fluiden Arbeitsmediums (M) mittels eines Wärmeeintrags in das Kühlelement (37) über das jeweilige Kaltsegment (K) der Kanalwand (5) ermöglicht wird.

5. Elektrisches Modul (30) nach einem der vorhergehenden Ansprüche, bei welchem der längliche Medienkanal (3) mit einem fluiden Arbeitsmedium (M) befüllt ist, das einen thermischen Ausdehnungskoeffizienten von wenigstens 200 · 10⁻⁶ K⁻¹ aufweist, wobei dieser thermische Ausdehnungskoeffizient des Arbeitsmediums (M) um wenigstens einen Faktor zwei höher liegt als ein thermischer Ausdehnungskoeffizient eines Materials der Kanalwand (5).

6. Elektrisches Modul (30) nach Anspruch 5, bei welchem das fluide Arbeitsmedium (M) eine Wärmeleitfähigkeit von wenigstens 0,1 W/(m K) aufweist und/oder bei welchem die Kanalwand (5) aus einem Material mit einer Wärmeleitfähigkeit von wenigstens 1 W/(m K) gebildet ist.

7. Elektrisches Modul (30) nach einem der vorhergehenden Ansprüche, bei welchem die Kanalwand (5) mit einem auxetischen Material gebildet ist.

8. Elektrisches Modul (30) nach einem der vorhergehenden Ansprüche, bei welchem die miteinander abwechselnden Warmsegmente (W) und Kaltsegmente (K) bezüglich ihrer lokalen Längsrichtung (x) jeweils eine Segmentlänge aufweisen, welche in einem Bereich zwischen 1 mm und 10 mm liegt.

9. Elektrisches Modul (30) nach einem der vorhergehenden Ansprüche, bei welchem der längliche Medienkanal (3) eine Kanalbreite in einem Bereich zwischen 0,1 mm und 4 mm aufweist.

10. Elektrisches Modul (30) nach einem der vorhergehenden Ansprüche, bei welchem das wenigstens ein strömungsleitendes Element (7) durch eine schräg zur lokalen Längsrichtung (x) ausgerichtete Lamelle, durch ein Teslaventil und/oder durch ein Rückschlagventil gebildet ist.

11. Elektrisches Modul (30) nach einem der vorhergehenden Ansprüche, bei welchem wenigstens ein Längssegment der Kanalwand (5) als Zwischensegment (N) ausgebildet ist, welches ein Paar aus Warmsegmenten (W) und/oder Kaltsegmenten (K) verbindet und welches eine Segmentlänge aufweist, die größer ist als eine mittlere Segmentlänge der Warmsegmente (W) und Kaltsegmente (K).

12. Elektrisches Modul (30) nach einem der vorhergehenden Ansprüche, bei welchem die Kanalwand (5) im Bereich wenigstens eines Warmsegments (W) eine lokale Ausnehmung aufweist, durch welche das elektrische Bauteil (35) unmittelbar von dem fluiden Arbeitsmedium (M) anströmbar ist.

13. Kühlvorrichtung (1) zur Kühlung wenigstens einer Wärmequelle (35),
- wobei die Kühlvorrichtung (1) einen ringförmig geschlossenen länglichen Medienkanal (3) zur Zirkulation eines fluiden Arbeitsmediums (M) in einem geschlossenen Kreislauf aufweist,
- wobei der ringförmig geschlossene Medienkanal (3) durch eine Kanalwand (5) begrenzt ist, welche wenigstens in einem Teilbereich (40) in ihrer lokalen Längsrichtung (x) in eine Mehrzahl von miteinander abwechselnden Warmsegmenten (W) und Kaltsegmenten (K) unterteilt ist,
- wobei die Warmsegmente (W) jeweils im Bereich der wenigstens eine Wärmequelle (35) angeordnet sind und thermisch derart mit dieser gekoppelt sind, dass sie eine Entwärmung der Wärmequelle mittels eines lokalen Wärmeeintrags (Qᵢₙ) in das fluide Arbeitsmedium (M) über das jeweilige Warmsegment (W) der Kanalwand (5) ermöglichen,
- wobei zwischen den einander benachbarten Warmsegmenten (W) und Kaltsegmenten (K) jeweils ein Übergangsbereich (T) gebildet ist,
- und wobei in wenigstens einer Teilmenge dieser Übergangsbereiche (T) jeweils wenigstens ein strömungsleitendes Element (7) angeordnet ist, mit welchem einem durch den lokalen Wärmeeintrag (Qᵢₙ) thermisch angetriebenen Transport des fluiden Arbeitsmediums (M) eine Vorzugsrichtung (r) aufgeprägt werden kann.

14. Verfahren zum Betrieb eines elektrischen Moduls (30) nach einem der vorhergehenden Ansprüche, bei welchem das wenigstens eine elektrische Bauelement (35) mittels eines fluiden Arbeitsmediums (M) gekühlt wird, welches innerhalb des länglichen Medienkanals (3) in einem geschlossenen Kreislauf zirkuliert,
- wobei der Transport des fluiden Arbeitsmediums (M) durch den lokalen Wärmeeintrag (Qᵢₙ) thermisch angetrieben wird
- und wobei der Transport entlang einer Vorzugsrichtung (r) erfolgt, welche durch das wenigstens ein strömungsleitendes Element (7) in einen Stoffstrom des fluiden Arbeitsmediums (M) eingeprägt wird.

15. Verfahren zum Betrieb eines elektrischen Moduls nach Anspruch 14, bei welchem das fluide Arbeitsmedium (M) einen einphasigen Stoffstrom ausbildet.
